# EUROPÄISCHE PATENTSCHRIFT

(11) **EP 2 499 275 B1**
(45) Veröffentlichungstag und Bekanntmachung des Hinweises auf die Patenterteilung: **28.08.2013**
(21) Anmeldenummer: 10784281.7
(22) Anmeldetag: 12.11.2010
(51) Int. Cl.: C23C 16/34, C23C 16/36, C23C 30/00

(54) **BESCHICHTETE KÖRPER AUS METALL, HARTMETALL, CERMET ODER KERAMIK SOWIE VERFAHREN ZUR BESCHICHTUNG DERARTIGER KÖRPER**
COATED BODIES MADE OF METAL, HARD METAL, CERMET OR CERAMIC MATERIAL AND METHOD FOR COATING SUCH BODIES
CORPS REVÊTUS EN MÉTAL, MÉTAL DUR, CERMET OU CÉRAMIQUE AINSI QUE PROCÉDÉ DE REVÊTEMENT DE TELS CORPS

(30) Priorität: 12.11.2009 DE 102009046667
(43) Veröffentlichungstag der Anmeldung: 19.09.2012
(73) Patentinhaber: Fraunhofer-Gesellschaft zur Förderung der angewandten Forschung e.V., 80686 München (DE)
(72) Erfinder: ENDLER, Ingolf, 01640 Coswig (DE); HÖHN, Mandy, 01277 Dresden (DE)
(74) Vertreter: Rauschenbach, Dieter
(86) Internationale Anmeldenummer: PCT/EP2010/067371
(87) Internationale Veröffentlichungsnummer: WO 2011/058132

(56) Entgegenhaltungen:
- DE-B3-102007 000 512
- FR-A1- 2 784 694
- ENDLER I ET AL: "Aluminum-rich TiAlCN coatings by Low Pressure CVD", 25. November 2010 (2010-11-25), SURFACE AND COATINGS TECHNOLOGY, ELSEVIER, AMSTERDAM, NL, PAGE(S) 1307 - 1312, XP027507482, ISSN: 0257-8972 [gefunden am 2010-09-07] das ganze Dokument

## Beschreibung

### TECHNISCHES GEBIET

Die Erfindung betrifft beschichtete Körper aus Metall, Hartmetall, Cermet oder Keramik, beschichtet mit einem ein- oder mehrlagigen Schichtsystem, das mindestens eine Hartstoffkompositschicht enthält, sowie Verfahren zur Beschichtung derartiger Körper. Die auf den Körpern erzeugte erfindungsgemäße Hartstoffschicht zeichnet sich durch eine Kompositstruktur mit glatter, homogener Oberfläche, hoher Oxidationsbeständigkeit und großer Härte aus und ist insbesondere als Verschleißschutzschicht auf Si₃N₄- und WC/Co-Wendeschneidplatten und Stahl-Bauteilen einsetzbar.

### STAND DER TECHNIK

Werkzeuge für die spanende Bearbeitung müssen hohe Anforderungen hinsichtlich Standfestigkeit und Abrasionsbeständigkeit erfüllen. Beschichtungen auf Basis von Nitriden, Carbiden und Carbonitriden des Titans werden seit langem als Verschleißschutzschichten eingesetzt. In den letzten Jahren ging der Trend dahin, diese Beschichtungen durch den Einbau von Aluminium mit einer höheren Oxidationsbeständigkeit zu versehen.

TiAIN-Schichten mit kubischer NaCl-Struktur sowie verschiedene Verfahren zu deren Herstellung sind bekannt. Dabei werden monophasige fcc-TiAIN-Schichten oder Mischungen von fcc-TiAIN und hexagonalem AIN unter Verwendung von PVD-, Plasma-CVD- und thermischen CVD-Verfahren hergestellt (WO 03/085152 A2;
K. Kawata, H. Sugimura, O.Takai, Thin Solid Films, 390 (2001) S. 64-69; DE 10 2005 032 860 B4).

Durch den Einbau von Kohlenstoff und von weiteren Metallen werden diese Schichten kontinuierlich weiter verbessert, wobei sowohl PVD- als auch CVD-Verfahren eingesetzt werden.

Schichtsysteme mit reinen fcc-TiAICN-Schichten werden beispielsweise in CN 101319302A erläutert. Dabei wird eine Methode zur PVD-Abscheidung einer linear graduierten TiAICN-Schicht beschrieben, wobei der C/N-Gradient durch gezielte Dosierung von N₂ und C₂H₂ erzeugt wird.

Die Patentanmeldung WO 98/10120 A1 befasst sich mit einem PVD-beschichteten Werkstück mit mindestens zwei aufeinander folgenden Schichten bestehend aus TiN, TiCN, TiAlN und TiAlCN.

Ein Werkstück mit einer verschleißmindernden Beschichtung bestehend aus kombinierten Nitriden, Carbonitriden und Carbiden von Ti und Al wird in dem Patent US 2002/0136933 A1 beschrieben.

In JP 05337705 A wird ein beschichteter Schneidkörper mit einer Schicht bestehend aus Ti, Al und N und/oder C patentiert. Diese Beschichtung wird mittels Plasma-CVD hergestellt.

Bekannt sind auch Schichten mit einer Mischung aus fcc-TiAIN und h-AlN (DE 10 2007 000 512 B3) sowie Schichten einer Mischung aus fcc-(Ti_{y}AlₓMe_{1-x-y})N mit h-AlN wobei Me die Metalle Zr, Hf, V, Nb, Ta, Cr, Mo, W oder Si umschließt (US 2004/0115484 A1).

Es sind auch Nanokomposit-Schichten bestehend aus fcc-TiAICN und amorphem Kohlenstoff bekannt (US 2003/143402 A1; J. Shieh and M. H. Hon, Plasmaenhanced chemical-vapor deposition of titanium aluminium carbonitride/amorpouscarbon nanocomposite thin films, J. Vac. Sci. Technol., Jan/Feb 2002, A20,(1), S. 87-92). Diese Schichten werden mittels Plasma-CVD hergestellt. Die nanoskaligen TiAlCN-Körner sind in eine Matrix aus amorphem Kohlenstoff eingebettet.

Weiterhin bekannt ist die Zumischung weiterer Metalle zu fcc-TiAlN-Schichten.

EP 1 574 594 A1 beschreibt kohlenstoffhaltige Hartstoff-PVD-Schichten mit nanokristallinem Gefüge der Zusammensetzung (AlₓMe1_{y}Me2_{z})CuE1ᵥE2_{w} mit: Me1 und Me2 Metalle x > 0,4, x + y + z = 1 und y, z ≥ 0 sowie 1 > u > 0 und u + v + w = 1 und v, w ≥ 0. Dabei ist der Kohlenstoffgehalt in den Korngrenzen höher als in den Nanokristallen.

Ein hartstoffbeschichteter Körper mit einer CVD-Schicht aus (Ti,Me)₁₋ₓAlₓ(C_{y}N_{z}) mit Me = Zr und/oder Hf wird in WO 2009/112117 A1 beschrieben. Diese Schichten zeichnen sich durch eine hohe Oxidationsbeständigkeit und einen hohen Abrasionsfestigkeit aus.

### DARSTELLUNG DER ERFINDUNG

Der Erfindung liegt die Aufgabe zugrunde, für Körper aus Metall, Hartmetall, Cermet oder Keramik ein Schichtsystem zu entwickeln, das ein- oder mehrlagig ist und das mindestens eine Hartstoffkompositschicht aufweist, welche als Hauptphasen kubisches TiAlCN und hexagonales AIN enthält und die sich durch eine Kompositstruktur mit glatter, homogener Oberfläche, hoher Oxidationsbeständigkeit und großer Härte auszeichnet. Eingeschlossen in diese Aufgabe ist die Entwicklung eines Verfahrens zum kostengünstigen Erzeugen derartiger Beschichtungen.

Diese Aufgabe wird mit den Merkmalen der Patentansprüche gelöst, wobei die Erfindung auch Kombinationen der einzelnen abhängigen Ansprüche im Sinne einer UND-Verknüpfung mit einschließt.

Die erfindungsgemäß beschichteten Körper sind dadurch gekennzeichnet, dass sie mit einem ein- oder mehrlagigen Schichtsystem beschichtet sind, das mindestens eine Hartstoffkompositschicht aufweist, die als Hauptphasen kubisches TiAlCN und hexagonales AIN enthält, wobei das kubische TiAlCN ein mikrokristallines fcc-Ti₁₋ₓAlₓC_{y}N_{z} mit x > 0,75, y = 0 bis 0,25 und z = 0,75 bis 1 mit einer Kristallitgröße von ≥ 0,1 µm ist, und wobei diese Kompositschicht im Korngrenzenbereich zusätzlich amorphen Kohlenstoff mit einem Massenanteil von 0,01 % bis 20 % enthält.

Die erfindungsgemäße TiAICN-Beschichtung zeichnet sich durch eine mikrokristalline Kompositstruktur aus, wobei die beiden Hauptphasen fcc-Ti₁₋ₓAlₓC_{y}N_{z} mit x > 0,75 und hexagonales AIN eine hohe Härte und Oxidationsbeständigkeit gewährleisten und der amorphe Kohlenstoff zur Reduzierung der Reibung beiträgt.
Die hohe Härte der Kompositschicht bleibt über einen breiten
Zusammensetzungsbereich bis 50 Ma.-% h-AlN erhalten.

Demgegenüber besitzen TiAICN-Nanokompositschichten nach dem Stand der Technik wegen des geringeren Aluminiumgehaltes und der Einbettung der TiAICN-Kristalle in amorphen Kohlenstoff nur eine begrenzte Oxidationsbeständigkeit. Die amorphe Kohlenstoffmatrix verbrennt ab 400°C. Damit ist der Zusammenhalt in der Nanokompositschicht bei hohen Temperaturen nicht mehr gegeben.

Die erfindungsgemäße TiAICN-Schicht zeigt dagegen aber eine überraschend hohe Oxidationsbeständigkeit bis 800°C. Der hohe Aluminiumgehalt der Hauptkomponenten fcc-TiAICN und hexagonales AIN sowie die mikrokristallinen Struktur sind offensichtlich die Basis für die Aufnahme einer bestimmten Menge an reibungsminderndem amorphen Kohlenstoff, ohne dass die Oxidationsbeständigkeit nachteilig beeinflusst wird.

Die erfindungsgemäße Beschichtung kann wie folgt zweckmäßig und vorteilhaft ausgestaltet sein:
Neben dem mikrokristallinem fcc-Ti₁₋ₓAlₓC_{y}N_{z} können in der Hartstoffkompositschicht weitere Ti-Verbindungen enthalten sein, die aus Ti₁₋ₓAlₓN in Wurtzitstruktur und/oder TiN bestehen.

Der amorphe Kohlenstoff liegt vorzugsweise als graphitischer sp²-Kohlenstoff vor. Erfindungsgemäß kann das mehrlagige Schichtsystem aus mehreren TiAICN-Hartstoffkompositschichten mit unterschiedlichen Gehalten an amorphem Kohlenstoff und/oder hexagonalem AIN bestehen.

Die Hartstoffkompositschicht kann einen Gradienten hinsichtlich des Massenanteils an hexagonalem AlN zwischen 0,1 % und 50 % und/oder des Massenanteils an amorphem Kohlenstoff zwischen 0,1 % und 20 % aufweisen.

Zweckmäßigerweise weist die erfindungsgemäße Hartstoffkompositschicht eine Schichtdicke zwischen 0,1 µm und 30 µm auf.

Das mikrokristalline fcc-TiAICN besitzt vorzugsweise eine Kristallitgröße zwischen 0,1 µm und 1 µm.

Zur Herstellung derartig beschichteter Körper beinhaltet die Erfindung ein Verfahren, bei dem die Körper mit mindestens einer Hartstoffkompositschicht versehen sind, die als Hauptphasen mikrokristallines fcc-Ti₁₋ₓAlₓC_{y}N_{z} mit x > 0,75, y = 0 bis 0,25 und z = 0,75 bis 1 und hexagonales AIN aufweist und die zusätzlich amorphen C mit einem Massenanteil von 0,01 % bis 20 % enthält, wobei die Kompositschicht unter Verwendung einer Gasmischung mit Ti-, Al-, C- und N-Precursoren in einem LPCVD-Prozess bei Temperaturen zwischen 700°C und 900°C und bei Drücken zwischen 10² Pa und 10⁵ Pa ohne zusätzliche Plasmaanregung auf dem Körper abgeschieden wird.

Das erfindungsgemäße Verfahren kann wie folgt zweckmäßig und vorteilhaft ausgestaltet sein:
Als Precursoren für die Abscheidung der Hartstoffkompositschicht können in der Gasmischung vorteilhaft Titanhalogenide, Aluminiumhalogenide, reaktive Stickstoffverbindungen, Kohlenwasserstoffe und/oder Verbindungen mit Kohlenstoff und Stickstoff verwendet werden.

Als reaktive Stickstoffverbindung können vorteilhaft NH₃ und als Kohlenwasserstoffe C₂H₄ oder C₂H₂ verwendet werden.

Zweckmäßigerweise können der Gasmischung zur Abscheidung der Hartstoffkompositschicht H₂ und/oder N₂ und/oder Edelgas zugemischt werden.

### BEISPIELE ZUR AUSFÜHRUNG DER ERFINDUNG

Nachstehend ist die Erfindung an Ausführungsbeispielen und der zugehörigen Abbildungen näher erläutert. Die Abbildungen zeigen:
Abb.1: das XRD-Diffraktogramm der Hartstoffkompositschicht gemäß Ausführungsbeispiel 1, bestehend aus fcc-TiAICN, h-AlN und amorphem Kohlenstoff,
Abb. 2: das Raman-Spektrum der Hartstoffkompositschicht gemäß Ausführungsbeispiel 1; bestehend aus fcc-TiAICN, h-AlN und amorphem Kohlenstoff,
Abb. 3: das XRD-Diffraktogramm der Hartstoffkompositschicht gemäß Ausführungsbeispiel 2, bestehend aus fcc-TiAlCN, h-AlN und amorphem Kohlenstoff.

### Beispiel 1

Auf WC/Co-Hartmetallwendeschneidplatten wird zunächst eine 1µm dicke TiN-Anbindungsschicht und anschließend die erfindungsgemäße Schicht mittels eines CVD-Prozesses aufgebracht.

Der Beschichtungsprozess erfolgt in einem Heißwand-CVD-Reaktor mit einem Innendurchmesser von 75 mm. Für die CVD-Beschichtung wird eine Gasmischung eingesetzt, die 51,8 Vol.-% H₂, 1,3 Vol.-% AlCl₃, 0,3 Vol.-% TiCl₄, 25,9 Vol.-% Ar und 4,9 Vol.-% NH₃, 1,3 Vol.-% C₂H₄ sowie 14,5 Vol.-% N₂ enthält. Die Abscheidungstemperatur beträgt 850°C und der Prozessdruck ist 0,8 kPa. Nach einer Beschichtungszeit von 30 min wird eine 5 µm dicke TiAICN-Schicht erhalten.

Mittels WDX-Untersuchung wurde ein C-Gehalt von 0,5 At.-%, ein Aluminiumgehalt von 36,2 At.-%, ein Titangehalt von 8,1 At.-%, ein Chlorgehalt von 0,3 At.-% und ein Stickstoffgehalt von 54,9 At.-% innerhalb der Schicht ermittelt.

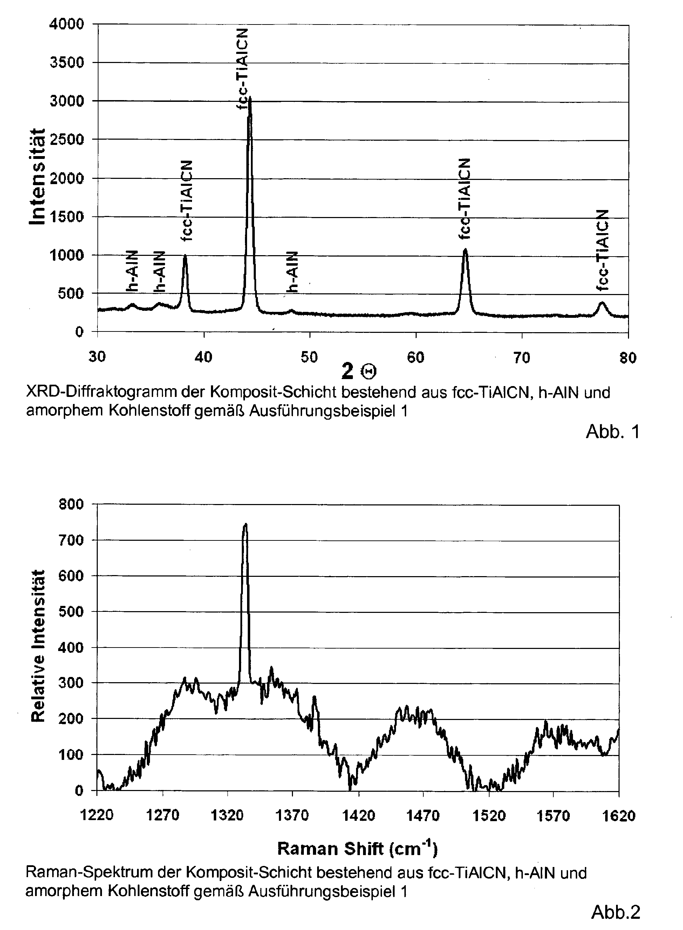

Diese Schicht wurde mittels röntgenographischer Dünnschichtanalyse im streifenden Einfall untersucht (siehe Röntgendiffraktogramm Abb. 1). Das Diffraktogramm zeigt eine Phasenmischung bestehend aus fcc-TiAICN und h-AlN. Eine Rietveld-Analyse ergab für die kristallinen Schichtbestandteile einen Gehalt von 3,5 Ma.-% h-AlN und 96,5 Ma.-% fcc-TiAICN. Amorphe Schichtbestandteile können mit den röntgenographischen Untersuchungsmethoden nicht erfasst werden.

Zum Nachweis des amorphen Kohlenstoffs wurden TEM- und Raman-Untersuchungen durchgeführt. Die TEM-Untersuchung zeigte eine Kohlenstoff-Anreicherung im Korngrenzenbereich. Das Raman-Spektrum (siehe Abb. 2) enthält zwei breite Banden, die erste zwischen 1200 und 1400cm⁻¹ und die zweite zwischen 1500 und 1700cm⁻¹, die der D- und G-Bande eines amorphen sp²-Kohlenstoffs entsprechen.

Die in der TEM-Untersuchung ermittelte Kristallitgröße für das fcc-TiAICN beträgt 0,4 µm.

Mikrohärtemessungen mit einem Vickers-Indenter ergeben eine Härte von 31,5 ± 0,6 GPa.

Die erfindungsgemäße Hartstoffschicht zeichnet sich durch eine Komposit-Struktur mit glatter, homogener Oberfläche, hoher Oxidationsbeständigkeit und hoher Härte aus.

### Beispiel 2

Auf Si₃N₄-Keramikwendeschneidplatten wird zunächst eine 1µm dicke TiN-Anbindungsschicht und anschließend die erfindungsgemäße Schicht mittels eines CVD-Prozesses aufgebracht.

Der Beschichtungsprozess erfolgt in einem Heißwand-CVD-Reaktor mit einem Innendurchmesser von 75 mm. Für die CVD-Beschichtung wird eine Gasmischung eingesetzt, die 51,7 Vol.-% H₂, 1,2 Vol.-% AlCl₃, 0,5 Vol.-% TiCl₄, 25,9 Vol.-% Ar und 4,9 Vol.-% NH₃, 1,3 Vol.-% C₂H₄ sowie 14,5 Vol.-% N₂ enthält. Die Abscheidungstemperatur beträgt 850°C und der Prozessdruck 0,8 kPa. Nach einer Beschichtungszeit von 25 min wird eine 5 µm dicke TiAICN-Schicht erhalten.

Mittels WDX-Untersuchung wurde ein C-Gehalt von 0,6 At.-%, ein Aluminiumgehalt von 36,6 At.-%, ein Titangehalt von 8,7 At.-%, ein Chlorgehalt von 0,3 At.-% und ein Stickstoffgehalt von 53,8 At.-% innerhalb der Schicht ermittelt.

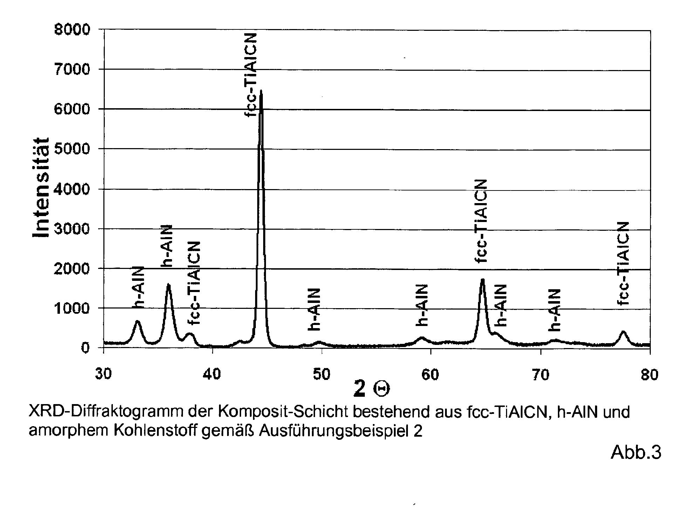

Diese Schicht wurde mittels röntgenographischer Dünnschichtanalyse im streifenden Einfall untersucht (siehe Röntgendiffraktogramm Abb. 3). Das Diffraktogramm zeigt eine Phasenmischung bestehend aus fcc-TiAICN und h-AlN mit einem höheren Anteil an h-AlN als in Beispiel 1. Eine Rietveld-Analyse ergab für die kristallinen Schichtbestandteile einen Gehalt von 29,0 Ma.-% h-AlN und 71,0 Ma.-% fcc-TiAICN.

Die Raman-Analyse ergibt ein identisches Spektrum wie in Abb. 2 mit einer D- und G-Bande für amorphen sp²-Kohlenstoff.

Die Analyse des Schichtgefüges mittels Rasterelektronenmikroskop zeigt eine etwas feinkörnigere Struktur mit einer Kristallitgröße des fcc-TiAICN von 0,1 µm.

Die mit einem Vickers-Indenter gemessene Härte beträgt 30,3 ± 0,5 GPa.

Die erfindungsgemäße Hartstoffschicht zeichnet sich durch eine sehr feinkörnige Komposit-Struktur mit glatter, homogener Oberfläche, exzellenter Oxidationsbeständigkeit und hoher Härte aus.

## Patentansprüche

1. Beschichtete Körper aus Metall, Hartmetall, Cermet oder Keramik, beschichtet mit einem ein- oder mehrlagigen Schichtsystem, das mindestens eine Hartstoffkompositschicht aufweist, die als Hauptphasen kubisches TiAlCN und hexagonales AIN enthält, **dadurch gekennzeichnet, dass** das kubische TiAICN ein mikrokristallines fcc-Ti₁₋ₓAlₓC_{y}N_{z} mit x > 0,75, y = 0 bis 0,25 und z = 0,75 bis 1 mit einer Kristallitgröße ≥ 0,1 µm ist, und dass diese Kompositschicht zusätzlich im Korngrenzenbereich amorphen Kohlenstoff mit einem Massenanteil von 0,01 % bis 20 % enthält.

2. Beschichtete Körper nach Anspruch 1, **dadurch gekennzeichnet, dass** neben dem mikrokristallinen fcc-Ti₁₋ₓAlₓC_{y}N_{z} weitere Ti-Verbindungen enthalten sind, die aus Ti₁₋ₓAlₓN in Wurtzitstruktur und/oder TiN bestehen.

3. Beschichtete Körper nach Anspruch 1, **dadurch gekennzeichnet, dass** der amorphe Kohlenstoff als graphitischer sp²-Kohlenstoff vorliegt.

4. Beschichtete Körper nach Anspruch 1, **dadurch gekennzeichnet, dass** das mehrlagige Schichtsystem aus mehreren TiAICN-Hartstoffkompositschichten mit unterschiedlichen Gehalten an amorphem Kohlenstoff und/oder hexagonalem AIN besteht.

5. Beschichtete Körper nach Anspruch 1, **dadurch gekennzeichnet, dass** die Hartstoffkompositschicht einen Gradienten hinsichtlich des Massenanteils an hexagonalem AIN zwischen 0,1 % und 50 % und/oder des Massenanteils an amorphem Kohlenstoff zwischen 0,1 % und 20 % aufweist.

6. Beschichtete Körper nach Anspruch 1, **dadurch gekennzeichnet, dass** die Hartstoffkompositschicht eine Schichtdicke zwischen 0,1 µm und 30 µm aufweist.

7. Beschichtete Körper nach Anspruch 1, **dadurch gekennzeichnet, dass** die Kristallitgröße des mikrokristallinen fcc-TiAICN im Bereich von 0,1 µm bis 1,0 µm liegt.

8. Verfahren zum Beschichten von Körpern aus Metall, Hartmetall, Cermet oder Keramik mit einem ein- oder mehrlagigen Schichtsystem, das mindestens eine Hartstoffkompositschicht aufweist, die als Hauptphasen mikrokristallines fcc-Ti₁₋ₓAlₓC_{y}N_{z} mit x > 0,75, y = 0 bis 0,25 und z = 0,75 bis 1 und hexagonales AIN aufweist und die zusätzlich amorphen Kohlenstoff mit einem Massenanteil von 0,01 % bis 20 % enthält, wobei die Kompositschicht unter Verwendung einer Gasmischung mit Ti-, Al-, C-und N-Precursoren in einem LPCVD-Prozess bei Temperaturen zwischen 700°C und 900°C und bei Drücken zwischen 10² Pa und 10⁵ Pa ohne zusätzliche Plasmaanregung auf dem Körper abgeschieden wird.

9. Verfahren nach Anspruch 8, **dadurch gekennzeichnet, dass** als Precursoren für die Abscheidung der Hartstoffkompositschicht in der Gasmischung Titanhalogenide, Aluminiumhalogenide, reaktive Stickstoffverbindungen, Kohlenwasserstoffe und/oder Verbindungen mit Kohlenstoff und Stickstoff verwendet werden.

10. Verfahren nach Anspruch 9, **dadurch gekennzeichnet, dass** als reaktive Stickstoffverbindung NH₃ und als Kohlenwasserstoffe C₂H₄ oder C₂H₂ verwendet werden.

11. Verfahren nach Anspruch 8, **dadurch gekennzeichnet, dass** der Gasmischung zur Abscheidung der Hartstoffkompositschicht H₂ und/oder N₂ zugemischt werden.

12. Verfahren nach Anspruch 8, **dadurch gekennzeichnet, dass** der Gasmischung zur Abscheidung der Hartstoffkompositschicht inertes Edelgas zugemischt wird.

## Claims

1. Coated bodies composed of metal, cemented hard material, cermet or ceramic and coated with a one-layer or multilayer layer system which has at least one hard material composite layer containing cubic TiAlCN and hexagonal AlN as main phases, **characterized in that** the cubic TiAlCN is a microcrystalline fcc-Ti₁₋ₓAlₓC_{y}N_{z} where x > 0.75, y = 0 to 0.25 and z = 0.75 to 1 having a crystallite size of ≥ 0.1 µm and **in that** this composite layer additionally contains amorphous carbon in a proportion by mass of from 0.01% to 20% in the grain boundary region.

2. Coated bodies according to Claim 1, **characterized in that** further Ti compounds consisting of Ti₁₋ₓAlₓN in the wurtzite structure and/or TiN are present in addition to the microcrystalline fcc-Ti₁₋ₓAlₓC_{y}N_{z}.

3. Coated bodies according to Claim 1, **characterized in that** the amorphous carbon is present as graphitic sp²-carbon.

4. Coated bodies according to Claim 1, **characterized in that** the multilayer layer system consists of a plurality of TiAlCN hard material composite layers having different contents of amorphous carbon and/or hexagonal AlN.

5. Coated bodies according to Claim 1, **characterized in that** the hard material composite layer has a gradient in respect of the proportion by mass of hexagonal AlN of from 0.1% to 50% and/or in respect of the proportion by mass of amorphous carbon of from 0.1% to 20%.

6. Coated bodies according to Claim 1, **characterized in that** the hard material composite layer has a layer thickness in the range from 0.1 µm to 30 µm.

7. Coated bodies according to Claim 1, **characterized in that** the crystallite size of the microcrystalline fcc-TiAlCN is in the range from 0.1 µm to 1.0 µm.

8. Process for coating bodies composed of metal, cemented hard material, cermet or ceramic with a one-layer or multilayer layer system which has at least one hard material composite layer which has microcrystalline fcc-Ti₁₋ₓAlₓC_{y}N_{z} where x > 0.75, y = 0 to 0.25 and z = 0.75 to 1 and hexagonal AlN as main phases and additionally contains amorphous carbon in a proportion by mass of from 0.01% to 20%, wherein the composite layer is deposited on the body using a gas mixture containing precursors for Ti, Al, C and N in an LPCVD process at temperatures in the range from 700°C to 900°C and pressures in the range from 10² Pa to 10⁵ Pa without additional plasma excitation.

9. Process according to Claim 8, **characterized in that** titanium halides, aluminium halides, reactive nitrogen compounds, hydrocarbons and/or compounds containing carbon and nitrogen are used as precursors for the deposition of the hard material composite layer in the gas mixture.

10. Process according to Claim 9, **characterized in that** NH₃ is used as reactive nitrogen compound and C₂H₄ or C₂H₂ is used as hydrocarbon.

11. Process according to Claim 8, **characterized in that** H₂ and/or N₂ are mixed into the gas mixture for deposition of the hard material composite layer.

12. Process according to Claim 8, **characterized in that** inert noble gas is mixed into the gas mixture for deposition of the hard material composite layer.

## Revendications

1. Corps revêtus en métal, métal dur, cermet ou céramique, revêtus avec un système de couche(s) monocouche ou multicouche qui comporte au moins une couche de composite de matières dures qui contient en tant que phases principales du TiAlCN cubique et de l'AlN hexagonal, **caractérisés en ce que** le TiAlCN cubique est un fcc-Ti₁₋ₓAlₓC_{y}N_{z} microcristallin où x > 0,75, y = 0 à 0,25 et z = 0,75 à 1 avec une taille de cristallites ≥ 0,1 µm, et **en ce que** cette couche composite contient en outre dans la zone de joint de grain du carbone amorphe, en une proportion en masse de 0,01 % à 20 %.

2. Corps revêtus selon la revendication 1, **caractérisés en ce qu**'en plus du fcc-Ti₁₋ₓAlₓC_{y}N_{z} microcristallin sont contenus d'autres composés de Ti qui consistent en Ti₁₋ₓAlₓN en structure de wurtzite et/ou TiN.

3. Corps revêtus selon la revendication 1, **caractérisés en ce que** le carbone amorphe est présent sous forme de carbone sp² graphitique.

4. Corps revêtus selon la revendication 1, **caractérisés en ce que** le système de couches multicouche consiste en plusieurs couches de composite de matières dures-TiAlCN à différentes teneurs en carbone amorphe et/ou AlN hexagonal.

5. Corps revêtus selon la revendication 1, **caractérisés en ce que** la couche composite de matières dures présente un gradient en ce qui concerne la proportion en masse d'AlN hexagonal entre 0,1 % et 50 % et/ou la proportion en masse de carbone amorphe entre 0,1 % et 20 %.

6. Corps revêtus selon la revendication 1, **caractérisés en ce que** la couche de composite de matières dures présente une épaisseur de couche comprise entre 0,1 µm et 30 µm.

7. Corps revêtus selon la revendication 1, **caractérisés en ce que** la taille de cristallites du fcc-TiAlCN microcristallin se situe dans la plage allant de 0,1 µm à 1,0 µm.

8. Procédé pour le revêtement de corps en métal, métal dur, cermet ou céramique avec un système de couche(s) mono- ou multicouche qui comporte au moins une couche de composite de matières dures qui contient en tant que phases principales du fcc-Ti₁₋ₓAlₓC_{y}N_{z} microcristallin où x > 0,75, y = 0 à 0,25 et z = 0,75 à 1 et de l'AlN hexagonal et qui contient en outre du carbone amorphe en une proportion en masse de 0,01 % à 20 %, dans lequel on dépose sur le corps la couche de composite en utilisant un mélange de gaz avec des précurseurs de Ti, Al, C et N dans un processus LPCVD à des températures comprises entre 700 °C et 900 °C et sous des pressions comprises entre 10² Pa et 10⁵ Pa sans excitation de plasma supplémentaire.

9. Procédé selon la revendication 8, **caractérisé en ce que** comme précurseurs pour le dépôt de la couche de composite de matières dures on utilise dans le mélange de gaz des halogénures de titane, des halogénures d'aluminium, des composés azotés réactifs, des hydrocarbures et/ou des composés comportant du carbone et de l'azote.

10. Procédé selon la revendication 9, **caractérisé en ce qu**'on utilise comme composé azoté réactif NH₃ et comme hydrocarbures C₂H₄ ou C₂H₂.

11. Procédé selon la revendication 8, **caractérisé en ce qu**'on ajoute H₂ et/ou N₂ au mélange de gaz pour le dépôt de la couche de composite de matières dures.

12. Procédé selon la revendication 8, **caractérisé en ce qu**'on ajoute un gaz rare inerte au mélange de gaz pour le dépôt de la couche de composite de matières dures.
